# EUROPÄISCHE PATENTSCHRIFT

(11) **EP 2 665 092 B1**
(45) Veröffentlichungstag und Bekanntmachung des Hinweises auf die Patenterteilung: **27.02.2019**
(21) Anmeldenummer: 12168291.8
(22) Anmeldetag: 16.05.2012
(51) Int. Cl.: H01L 23/373, H01L 33/64

(54) **Verfahren zur Herstellung eines Halbleiterelementes auf einem Kupfersubstrat mit dazwischenliegender Isolationsschicht**
Method for producing a semiconductor element on a copper substrate with intermediate insulation layer
Procédé de fabrication d'un élément semi-conducteur sur un substrat de cuivre avec une couche d'isolation intermédiaire

(43) Veröffentlichungstag der Anmeldung: 20.11.2013
(73) Patentinhaber: Microdul AG, 8045 Zürich (CH)
(72) Erfinder: Bucher, Benno, 8706 Meilen (CH); Stuber, Daniel, 6343 Rotkreuz (CH)
(74) Vertreter: Liebetanz, Michael

(56) Entgegenhaltungen:
- EP-A1- 2 390 914
- EP-A2- 1 993 133
- DE-A1-102009 000 192
- JP-A- 2008 198 706
- US-A1- 2004 056 346
- US-A1- 2010 270 515

## Beschreibung

### TECHNISCHES GEBIET

Die vorliegende Erfindung betrifft ein Verfahren zur Herstellung eines Halbleiterelementes, insbesondere von lichtemittierenden Dioden auf einem Kupfersubstrat, mit dazwischenliegender Isolationsschicht.

### STAND DER TECHNIK

Aus der gattungsbildenden WO 2011/095406 ist eine Leistungseinrichtung mit einem Leistungsmodul und einem Kühler bekannt, wobei das Leistungsmodul ein mindestens ein Leistungselement tragendes Substrat aufweist, das unter Zwischenschaltung einer Wärmesenke an dem Kühler angeordnet ist. Es wird dort ausgeführt, dass Leistungsmodule den Einsatz von beispielsweise DBC-Substraten (Direct-Bonded-Copper-Substrat) vorsehen, die mittels eines Wärmeleitmediums auf einem Kühler montiert werden, um eine Leistungseinrichtung zu bilden. Bei diesem Wärmeleitmedium, das eine Wärmesenke für das Leistungsmodul bildet, handelt es sich um hochelastische Klebverbindungen auf Silikonbasis. Bei konventionellen Leistungsmodulen ist insbesondere der Unterschied der thermischen Ausdehnungskoeffizienten zwischen dem Kühler und dem Substrat die Ursache für versagensrelevante thermische Spannungen im Bauteil. Eine direkte Anbindung des Substrats oder der Schaltungsanordnung auf einen Kühler kann aufgrund der thermomechanischen Anforderungen bisher nicht realisiert werden. Dieser Stand der Technik nutzt als Übergangsschicht, die als Isolation wirkt einen Metallkeramikverbundwerkstoff mit variablen Keramikanteil. Der Keramikanteil der Wärmesenke nimmt dabei in Richtung des Substrats zu, sodass in der Nähe des Substrats die Wärmesenke den höchsten Keramikgehalt und entfernt von dem Substrat nur einen geringen oder keinen Keramikgehalt aufweist. Der Keramikanteil der Wärmesenke kann in Richtung des Substrats stufenartig oder graduell zunehmen, um eine Anpassung der Ausdehnungskoeffizienten zwischen dem Kühler und der Schaltungsanordnung realisieren. Es wird bei diesem Stand der Technik als Vorteil angesehen, dass die Wärmesenke direkt mit dem Substrat in Verbindung stehen kann, ohne die sonst notwendige Schicht einer hochelastischen Klebverbindung beispielsweise auf Silikonbasis.

Der rein keramische Bereich der Wärmesenke kann dann nach dieser Druckschrift eine Deckschicht beziehungsweise ein Substrat mit hoher elektrischer Durchschlagfestigkeit (Isolation) bilden. Diese Deckschicht kann wahlweise vor der Infiltration eines porösen keramischen Vorkörpers mit schmelzflüssigem Metall versintert oder über ein Sinterverfahren mit einem bereits vollständig infiltrierten Metall-Keramik-Verbundwerkstoff verbunden.

Die EP 0 264 121 offenbart die Benutzung von Emaille als isolierende Schicht für ein Aluminium Substrat.

In der heutigen Beleuchtungstechnik werden immer häufiger Licht emittierende Dioden (LED) eingesetzt. Sie benötigen durch den höheren Wirkungsgrad für vergleichbare Lichtmengen weniger Energie. LED's sind energetisch sehr effiziente Lichtproduzenten und lösen auch Dank der langen Lebensdauer vermehrt Halogen- und Leuchtstoffröhrenlampen ab. Um im Hochleistungsbetrieb einen guten Wirkungsgrad und eine maximale Lebensdauer zu erreichen, muss die entstehende Wärme möglichst effizient vom LED-Chip abgeführt werden.

Die Lebensdauer und die Effizienz von Hochleistung-LEDs hängen entscheidend von der Temperatur TJ der Sperrschicht (Junction) ab. Bei einem Hochleistungsbetrieb kann die Temperatur der Sperrschicht auf deutlich über 100°C ansteigen. Je heisser die LED wird, desto mehr sinkt die Lebensdauer. Bei höherer Betriebsleistung verstärkt sich der Effekt nochmals.

LED's wie die Lumiled LUXEON Rebel von Philips werden bei 3 Volt Versorgungsspannung mit Strömen von 350 Milliampère bis 1 Ampere betrieben, so dass dabei eine erhebliche Wärme abgeleitet werden muss.

Um bei Leistungsbauteilen wie eben LED's die entstehende Wärme abführen zu können, bestehen Bestrebungen im Stand der Technik, diese Elemente direkt auf ein Kupfersubstrat zu montieren, weil Kupfer eine sehr hohe Wärmeleitfähigkeit besitzt. Dafür ist es dann aber erforderlich, eine Isolationsschicht vorzusehen.

Hochleistungs-LEDs werden zurzeit vor allem auf ein Keramiksubstrat (AlN) gelötet, welches seinerseits auf einem Submount montiert wird. Der Wärmewiderstand zwischen der Sperrschicht der Diode und dem Wärmekontakt beträgt aber bereits über 10 K/W.

Die Problematik der Montage von Halbleiter auf einer Wärmesenke wird in DE 10 2004 055 534 A1 erörtert und es werden dort Keramikpartikel auf einen Aluminiumträger gespritzt, um eine isolierende Schicht zu bilden. Die EP 2 234 156 verfeinert dieses Verfahren, wobei das Leistungsbauteil mittels Löten, Kleben, Drahtbonden oder auch Sintern an einem Stanzgitter befestigt werden.

Aus der DE 10 2004 031 431 ist ein Verfahren zur Herstellung von Puffern zum Abbau von Wärmespannungen bei thermoelektrischen Umwandlungselementen durch Anwendung einer Technik der Pulvermetallurgie bekannt, insbesondere ein Verfahren zur Herstellung von Metallkeramik-Schichtpresskörpern, die zum Abbau von Wärmespannungen eingesetzt werden, indem mehrere Schichten zwischen Keramikschicht und Kupferschicht vorgesehen werden.

Die DE 10 2009 000192 offenbart ein Verfahren zum Herstellen von Sinterverbindungen, wobei zwei Fügepartner miteinander versintert werden, wobei der eine Fügepartner ein Halbleiter und der andere Fügepartner eine Wärmesenke sein kann und wobei nichtorganisch beschichtete, metallische und/oder keramische Hilfspartikel vor dem Aufbringen des Sinterwerkstoffs im Fügebereich auf mindestens einem Fügepartner vorgesehen sind.

Die EP 2 390 914 zeigt eine Anordnung zweier Verbindungspartner mit einer Niedertemperatur-Drucksinterverbindung und ein Herstellungsverfahren hierzu, wobei mindestens einer der Verbindungspartner aus einem unedlen Metall besteht und dieses im Bereich angrenzend an die gegen das Verbindungsmittel gerichtete Kontaktfläche eine Metalloxidschicht aufweist.

Die EP 1 993 133 beschreibt Bondingmaterial für eine Metallbindung an einer Bindungsgrenzfläche, die eine höhere Bindungsstärke bei einer niedrigeren Temperatur ohne Anwendung von Druck aufweist. Das Bondingmaterial basiert auf Silber und enthält kein Harzbindemittel.

### DARSTELLUNG DER ERFINDUNG

Ausgehend von diesem Stand der Technik liegt der Erfindung die Aufgabe zugrunde, Leistungsbauteile, insbesondere LEDs mit einem preiswerten Prozess direkt auf Kupfer als Kühlkörpermaterial zu befestigen, wobei eine ausreichende Isolation bei Niederspannungsanwendungen verbunden werden soll mit dem Kompensieren der thermischen Spannung zwischen den unterschiedlichen Materialien.

Diese Aufgabe wird erfindungsgemäss für ein eingangs genanntes Verfahren mit den Merkmalen des Anspruchs 1 gelöst.

Bei einem Verfahren zur Herstellung eines Halbleiterelementes, insbesondere von lichtemittierenden Dioden, auf einem Kupfersubstrat mit dazwischenliegender Isolationsschicht wird auf dem Kupfersubstrat vor Aufbringen der Isolationsschicht eine Sinter-Kupferschicht aufgebracht.

Vorteilhafterweise besteht die als Paste aufgetragene zu sinternde Kupferschicht aus Kupferpulver oder Kupfer-Metall Gemisch und einem organischen Verdünnungsmittel.

Dabei kann das Kupferpulver eine Nennkorngrösse von 5 bis 20 Mikrometer, insbesondere von 10 Mikrometer haben. Es kann vorteilhafterweise in Flockenform vorliegen. Beim organischen Verdünnungsmittel ist HSV100 von Heraeus (www.heraeus.com) eine vorteilhafte Wahl.

Für eine qualitativ gute Schichtenfolge ist das Ausgangsmaterial Kupfer eine sauerstofffreie Kupferlegierung.

Die Sinterkupferschicht kann auf das Kupfersubstrat durch Siebdruck mehrmals aufgetragen und unter einer Stickstoffatmosphäre ausgehärtet werden, vorteilhafterweise bei einer Temperatur von 800 bis 950 Grad Celsius.

Eine Dielektrikumspaste kann als die Isolationsschicht auf und in die Sinterkupferschicht auf dem Kupfersubstrat, insbesondere durch Siebdruck, aufgetragen und anschliessend ausgehärtet werden, vorteilhafterweise bei einer Temperatur von 800 bis 950 Grad Celsius.

Schliesslich kann eine Leiterbahnpaste auf die unteren Schichten auf dem Kupfersubstrat, insbesondere durch Siebdruck, aufgetragen und anschliessend ausgehärtet werden, vorteilhafterweise bei einer Temperatur von 800 bis 950 Grad Celsius.

Damit ist das Verfahren gemäss der Erfindung mit Sinterschicht, die Isolationsschicht und ggf. Leiterbahnschicht vorteilhaft durch Dickschichttechnik zu realisieren, so dass die Montage nicht beispielsweise auf aufwendigen Nanoschichten beruht, sondern vielmehr auf der technisch vorteilhaften kostengünstigen Dickschichttechnik.

Die Dickfilmtechnik ist eine bewährte und effiziente Herstellungsmethode in der Produktion von Elektronikbauteilen. Die im Siebdruck hergestellten Platten sind besonders für kostengünstige Anwendungen ideal. Die Kombination aus Siebdruck und Surface-Mounted-Device (SMD)-Elementen ermöglicht zudem eine kompakte Anordnung von gesamten elektrischen Schaltungen.

Um die Leiterbahnen elektrisch vom Kupfersubstrat zu isolieren, wird per Dickfilmtechnik eine Isolationsschicht aus Dielektrikum zwischen Substrat und Chip aufgetragen. Bisher konnte dies in der Technik noch nicht realisiert werden, weil die stark unterschiedlichen Wärmeausdehnungskoeffizienten von Dielektrikum und Kupfer zu einer Absplitterung der Schichten geführt haben: die Schichten werden bei 900°C eingebrannt, wobei während dem Abkühlvorgang hohe thermische Spannungen zwischen der Beschichtung und dem Substrat entstehen.

Mit dem neuen Herstellungsverfahren kann Kupfer im Siebdruckverfahren beschichtet werden, so dass es möglich ist, temperatursensible Anwendungen direkt auf Kupfer aufzubringen, um eine gute Wärmeabfuhr mit einer günstigen Herstellungsmethode zu kombinieren.

Durch die Reduktion der Betriebstemperatur eines solchen Leistungshalbleiters um 10 Grad Kelvin verdoppelt sich die Lebensdauer des Bauteils. Die Verwendung von Kupfer als Wärmesenke ist ein einfach verfügbares, einfach verarbeitbares und im Zusammenhang auch preisgünstiges Material.

Um Leitungsbauteile mit verschiedenen Potentialen aufbauen zu können, ist ein Isolator mit geringer Temperaturresistenz zu verwenden; er muss dünn ausgestaltet sein können. Durch das Einbringen einer Sinterschicht für die Absorption der mechanischen Spannung kann die Dicke der Isolationsschicht signifikant herabgesetzt werden.

Damit kann ein Halbleiter über eine dünne Isolationsschicht direkt auf einem Substrat montiert werden, oder für die Montage einer Isolationsschicht auf einem Kupfersubstrat.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: einen schematischen Querschnitt durch ein Leistungsbauteil in Gestalt einer LED nach dem Stand der Technik;
- Fig. 2: einen schematischen Querschnitt durch ein Leistungsbauteil in Gestalt einer LED nach einem Ausführungsbeispiel der Erfindung; und
- Fig. 3: einen Scan durch einen Schnitt durch die Grenzflächen mit der Sinterschicht.

### BESCHREIBUNG BEVORZUGTER AUSFÜHRUNGSFORMEN

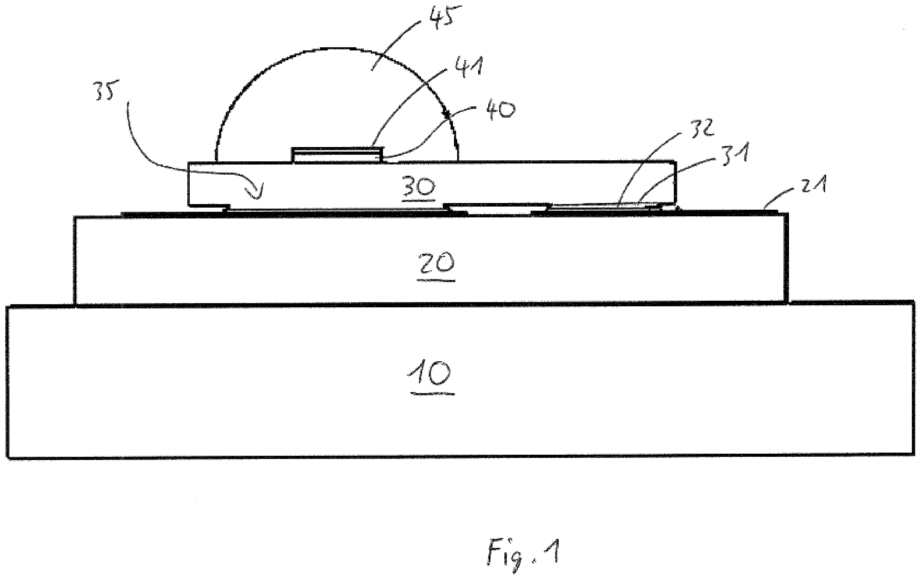

Die Fig. 1 zeigt einen schematischen Querschnitt durch ein Leistungsbauteil in Gestalt einer LED 40 nach dem Stand der Technik. Dabei verfügt die LED 40 über eine Sperrschicht, die beim Leuchten eine entsprechende Temperatur erreicht, wobei das Licht über den Dom 45 verteilt wird. Die LED 40 ist auf einem Keramiksubstrat 30 befestigt, welches über eine Kontaktierung 31, darunter befindliches Lot 32 und eine Metallisierung 21 eines Unterbaus 20 mit diesem Unterbau 20 (oder Submount) verbunden ist. Das Submount ist meistens aus FR4, AL2O3, AlN oder sonst einem temperaturstabilen Material gefertigt.

Der Bereich 35 ist dafür vorgesehen, die Wärmeableitung für die heisse LED 40 zu ermöglichen. Dafür ist der Unterbau 20 auf einer Wärmesenke 10 mittels Kleber oder Verschraubung befestigt. Die Wäremesenke 10 kann beispielsweise ein Kupferblock sein.

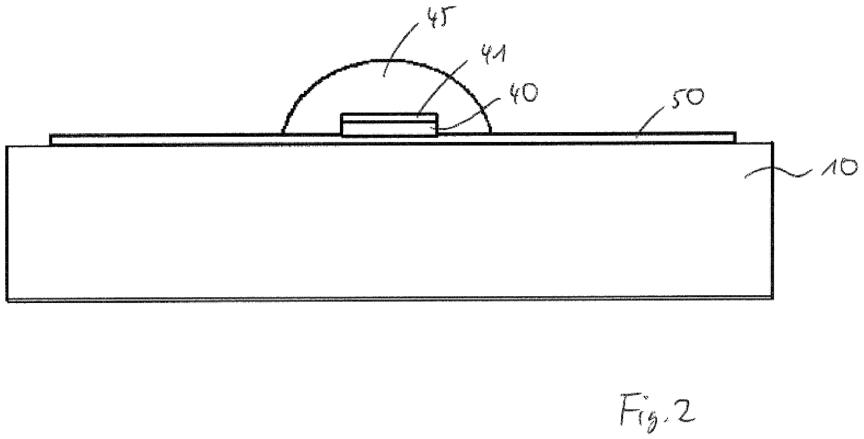

Die Fig. 2 zeigt einen schematischen Querschnitt durch ein Leistungsbauteil in Gestalt einer LED 40 nach einem Ausführungsbeispiel der Erfindung. Hier ist die LED 40 auf einer funktionellen isolierenden Schicht 50 befestigt, die auf einer Kupfer-Wärmesenke 10 vorhanden ist.

Die Kupferwärmesenke 10 für die nachfolgend gestesteten Proben hat die Dimensionen 40x40x2mm. Diese Grösse entspricht in den Dimensionen dem möglichen Anwendungsfall für eine LED-Montage.

Dabei besteht die Wärmesenke 10 beispielhaft aus einem Block aus Cu-ETP. Cu-ETP ist ein durch elektrolytische Raffination hergestelltes, sauerstoffhaltiges (zäh-gepoltes) Kupfer, das eine sehr hohe Leitfähigkeit für Wärme und Elektrizität aufweist. Halbzeug aus Cu-ETP wird meistens über gegossene Formate, wie z. B. Walzbarren und Gussdrähte, mittels Umformung gefertigt, da das Material ein ausgezeichnetes Formänderungsvermögen (Umformbarkeit) aufweist. In einem anderen bevorzugten Ausführungsbeispiel wird Cu-OFE verwendet. Cu-OFE ist ein hochreines, nicht desoxidiertes und sauerstofffreies Kupfer, das keine im Vakuum verdampfbaren Elemente beinhaltet und eine hohe Leitfähigkeit für Elektrizität und Wärme aufweist. Diese Kupfersorte besitzt neben einer sehr guten Warm- und Kaltumformbarkeit auch eine gute Korrosionsbeständigkeit, insbesondere gegen Atmosphäre (gut haftende Oxidschicht) bzw. Wasser und ist praktisch unempfindlich gegen Spannungsrisskorrosion.

Sowohl Cu-ETP als auch Cu-OFE besitzen die nötige Wärmeleitfähigkeit, wobei das Fehlen von Sauerstoff in Cu-OFE eine entsprechende Kontaminierung der Isolationsschicht beim Einbrennen sicher vermeidet und daher bevorzugter ist. Es können auch andere Legierungen wie Cu-Cr-Zr mit 0,5 bis 1,2 % Chrom eingesetzt werden. Die drei genannten Kupferlegierungen werden auch gemäss der Europäischen Norm CW004A, CW008A und CW106C genannt.

Die Isolationsschicht 50 hat den Zweck, die Kupferleiterbahnen der Schaltung (in der Fig. 2 nicht dargestellt) auf der Isolationsschicht 50 vom Kupfersubstrat 10 elektrisch zu isolieren. Als Basis für die Isolationsschicht 50 sind handelsübliche Isolationsmaterialien in Gestalt von Dielektrika-Dickfilmpasten verwendet worden. Die Pasten basieren auf Siliziumoxidbasis, die nach dem Sintern eine dichte Keramikschicht bilden.

Um die Isolationsschicht 50 auf das Kupfersubstrat aufbrennen zu können, muss vor allem der Ausdehnungskoeffizient des Dielektrikums an das Kupfer der Wäremesenke 10 sowie an die LED 40 bzw. den Submount, wenn als LED-Modul vorhanden, angepasst werden. Weiter soll die Schicht 50 die entstehende Wärme der LED 40 gut abführen.

Dafür ist zur Verbesserung der Haftung vor dem Bedrucken mit dem Dielektikum eine feine Schicht aus Kupferpulver auf das Kupfersubstrat gesintert worden. Diese Schicht gewährleistete eine sehr gute Verankerung des Dielektrikums auf dem Kupfersubstrat. Die durch den Brennprozess induzierten thermischen Spannungen konnten dadurch kompensiert werden. Die Haftung wurde in einem Temperaturzyklentest mit nachfolgendem Schertest verifiziert. Die Versuche mit der Sinterschicht wurden mit verschiedenen Dielektrikapasten durchgeführt. Eine exzellent haftende und dichte Schicht konnte beispielsweise mit der Paste IP9319 von Heraeus und mit der Paste LS-662 von Tanaka erreicht werden.

Durch diese vorgängig aufgebrachte Sinterschicht konnte eine gute Haftung des Dielektrikums auf Kupfer erreicht werden, so dass eine direkte Montage von Halbleiterelementen wie einer LED 40, auf einem Kupfersubstrat 10 erreicht worden ist. Die Wärmeleitfähigkeit der Schicht 50 erreicht eine weit über den Stand der Technik reichende Grösse.

Die Bestimmung der Wärmeleitfähigkeit erfolgte mit der Wärmefluss-Methode. Dabei wird bei konstanten Temperaturen der stationäre Wärmefluss bestimmt. Aus der Temperaturdifferenz und dem Wärmefluss lässt sich danach die Wärmeleitfähigkeit der Schicht bestimmen. Erste Abschätzungen der Wärmeleitfähigkeit wurden mit einer relativ einfachen Messung durchgeführt. Dazu wurde die Temperatur des Kupfersubstrats und die Temperatur der Heizung (Widerstand 10Ω) gemessen. Aus der Temperaturdifferenz und der elektrischen Leistung kann der Wärmewiderstand berechnet werden. Die Werte der besten Proben wurden anschliessend mit einer genaueren Apparatur mittels desselben Messprinzips bestimmt. Es wurde wiederum der Temperaturgradient über dem Dielektrikum bestimmt, jedoch mit einer deutlich besseren Genauigkeit. Die Berechnung des Wärmestroms konnte dabei ebenfalls genauer vorgenommen werden. Die Wärmeleitfähigkeitswerte bewegten sich zwischen 0.5 W/(m*K) bis 2 W/(m*K). Dies liegt deutlich über den bis Lösungen des Standes der Technik.

Die Heraeus Leiterbahnpaste "Heraeus C7257" wird wie das verwendete Dielektrikum per Siebdruck aufgebracht und bei 900°C eingebrannt. Die Paste ist kompatibel zu den verwendeten Dielektrikapasten von Heraeus.

Die Leiterbahnpaste von Tanaka, Tanaka TR-8901, wird wie die Leiterbahnpaste von Heraeus verarbeitet. Die Schicht wird per Siebdruck aufgebracht und wie das verwendete Dielektrikum bei 900°C eingebrannt. Die Paste ist wie bei Heraeus auf das Tanaka Dielektrikum abgestimmt.

Die Leiterbahnpaste wird nur zur Herstellung einer elektrischen Verbindung benötigt. Eine Dielektrikumspaste ist nicht unbedingt notwendig sondern ist optional. Die Leiterbahnpaste wird direkt auf die Isolationspaste aufgebracht, diese direkt auf die Sinterschicht.

Die Struktur der neuen gesinterten Dickschicht erlaubt die Kompensation der unterschiedlichen thermischen Ausdehnung von Substrat und Halbleiter, so dass sich keine überkritische, thermisch induzierte Spannung ausbildet. Der Wärmewiderstand der Sperrschicht zwischen der Diode 40 und dem Kupfersubstrat 10 beträgt dabei bis maximal 1 K/W.

Die Wärmeausdehnung von metallischen und keramischen Werkstoffen unterscheidet sich aufgrund der unterschiedlichen Bindungsart beträchtlich. So dehnt sich das Kupfersubstrat 10 bei Erwärmung wesentlich stärker aus, als die Keramikschicht der Isolationsschicht 50. Um ein Absplittern der Schicht zu verhindern, wird die Wärmeausdehnung innerhalb der aufgedruckten Schicht so angepasst, dass über die Schichthöhe y ein Gradient entsteht. Man kann davon ausgehen, dass der Verlauf des Wärmeausdehnungskoeffizientens α über die Höhe y der Isolationsschicht 50; ausgehend von einer Submount-Schicht 20 einem Gradienten entspricht. Im Bereich des Kupferblocks 10 besteht ein grösserer Wert des Wärmeausdehnungskoeffizienten a, während dieser im Bereich des Submounts 20 ein kleinerer Wert ist. Dazwischen kann ein beispielsweise mehr oder weniger als linear annehmbarer Gradient verlaufen. Er kann aber auch einen anderen Verlauf haben, von einem kleineren Wert im Submount 20 zu einem grösseren im Bereich des Kupferblockes 10.

Die Schicht 50 hat in der Kontaktzone zum Substrat 10 den Ausdehnungskoeffizient von Kupfer und in der Kontaktzone zum LED-Submount 20 jenen von Al₂O₃. Dadurch kann verhindert werden, dass es zur Bildung einer Spannungsüberhöhung an der Grenzfläche Kupfer-Dielektrikum und somit zur Ablösung kommt.

Es ist möglich die Sinterschicht mit der Zugabe von thermisch gut leitenden Füllstoffen zu versehen, um die Wärmeleitfähigkeit hoch zu halten; die zusätzliche Streuung der Phononen an den Grenzflächen der Füllstoffe und eine in der Matrix allgemein reduzierte freie Weglänge kompensieren die bessere Wärmeleitfähigkeit von solchen Füllstoffen.

Zur Vorbereitung der Sinterschicht wird das Kupfersubstrat 10 bevorzugt vorbehandelt. Dazu gehört eine Reinigung und Aufrauung. Um die Haftung der Isolationsschicht 50 zu verbessern, wurde die Oberfläche des Kupfersubstrats 10 auf unterschiedliche Arten vorbehandelt. Da Kupfer-Rohmaterial immer eine Oxidschicht hat, ist diese entfernt oder zumindest gereinigt worden. Durch das Erzeugen einer gewissen Rauigkeit der Oberfläche durch die Vorbehandlung konnte die aufgetragene Schicht besser mechanisch verankert werden.

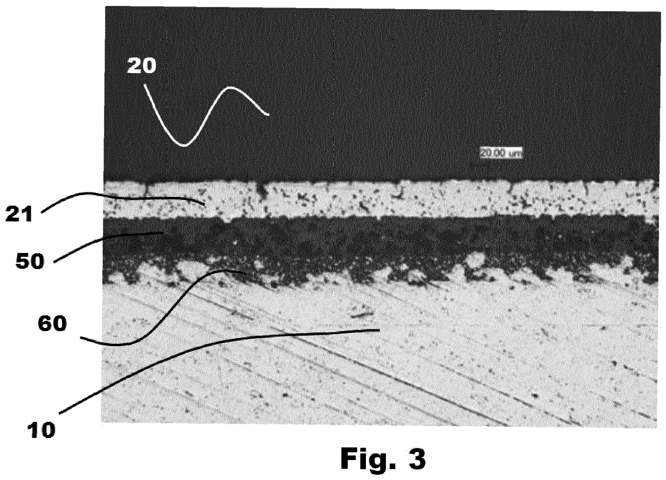

Um die Haftung der Isolationsschicht zu verbessern, ist eine Sinterschicht 60 aufgetragen worden. Die Sinterschicht 60 ist gemäss einem Ausführungsbeispiel, wie es in Fig. 3 durch einen Scan durch einen Schnitt durch die Grenzflächen dargestellt ist, aus einem flockigen Kupferpulver hergestellt worden, aus ECKA Kontaktargan 10 der Firma ecka Granulate GmbH & Co. KG aus Fürth, Deutschland. Dabei handelt es sich um Cu- oder Cu-Ag-Pulver mit Partikelgrössen im Bereich von 10 bis 20 Mikrometern.

Das Pulver wurde mit einem Verdünner HVS100 von Heraeus, Hanau, Deutschland, gemischt, bis sich eine druckbare Konsistenz ergab. Der Verdünner ist ein organisches Verdünnungsmittel. Die hergestellte Kupferpaste ist per Siebdruck beispielsweise mit einem 90/40mesh auf das Substrat 10 in Form der Kupferwärmesenke aufgebracht, getrocknet und anschliessend während 45 Minuten gesintert worden. Es ergab sich eine poröse Schicht 60 mit einer Dicke von ca. 30µm. Diese Schicht 60 enthält Einschlüsse des Substratsmaterials, hell in der Fig. 3 hinweisend zum Kupferblockmaterial 10. Diese Schicht 60 ist ein idealer Haftgrund für das Dielektrikum 50, da sich dieses in den Poren der Sinterschicht formschlüssig verankern kann. Zudem ergibt sich in der Sinterschicht 60 eine Mischzone aus Kupfer und Dielektrikum. Dies erzeugt einen Gradienten des Wärmeausdehnungskoeffizienten über die gesamte Schichthöhe y.

Nach dem Sinterprozess ergab sich eine sehr poröse Oberfläche des Substrats. In dieser porösen Oberfläche kann sich die Isolationsschicht 50 formschlüssig verankern. Zudem bildete die Sinterschicht 60 eine Art Puffer, welche die thermischen Spannung über die Schichthöhe verteilen und besser aufnehmen konnte. Die Schichtschicht hat die Haftung der Isolationsschicht massgebend verbessert.

Sintern ist ein thermisches Verfahren um Werkstoffe zu verdichten, ohne diese zu schmelzen. Es wird mit Temperaturen zwischen 65-80% der Schmelztemperatur des höher schmelzenden Werkstoffes gearbeitet. Durch die Temperatureinwirkung kommt es zur Diffusion der Atome entlang den Grenzflächen der einzelnen Werkstoffteile. Durch die Diffusion kommt es zu einer Verminderung der Grenzflächen und somit zu einem energetisch günstigeren Zustand, was zu einer stoffschlüssigen Verbindung führt. Da hier mit feinen Pulvern gearbeitet wird, entsteht viel Kontaktfläche, wo die Diffusion stattfinden kann.

Die Proben mit einer vorgängig aufgebrachten Sinterschicht zeigten im direkten Vergleich zu den Proben ohne Sinterschicht eine deutlich bessere Haftung auf dem Kupfersubstrat. Selbst bei Proben mit einem grossen Verzug haftete die Schicht stabil auf dem Substrat. Für die weiteren Versuche wurde daher immer zuerst eine Sinterschicht aufgebracht. Durch das Aufbringen der Sinterschicht konnte die Haftung für das Dielektrikum IP9227, IP9319 und LS-662 gewährleistet werden. Detaillierte Ergebnisse der Haftung von Proben mit Sinterschicht sind im folgenden aufgeführt. Dabei ist ein an den Military-Standart 883 (MIL-STD-883G) angelehnter Abschertest durchgeführt worden. Für die Versuche wurden 2.3x2.3mm grosse 4Ω-Widerstände im Schmelzlötverfahren auf die Proben aufgebracht. Daraus ergab sich eine Abscherfläche von 5.29mm2. Es wird ein befestigtes SMD-Bauteil von dem Substrat abgeschert und dabei die nötige Kraft für die Abscherung gemessen.

Dabei sind 4Ω-Widerstände mit der Grundfläche von 5.29mm2 mit einer Reflow-Lötpaste auf das zu testende Substrat aufgebracht worden. Die Abreissfläche wurde jedoch bei der einen Siebdruckgeometrie durch die 4mm2 grossen Leiterbahnpadflächen begrenzt. Da der MILSTD883G aber für Abreissflächen ab 63in2 (entspricht 4.06 mm2) eine konstant bleibende Belastung vorsieht, verursacht die unterschiedliche Abreissfläche keinen Unterschied in der minimalen Lastanforderung.

Bei einem Sollwert von 1.24kg/mm2 ist aus der Tabelle gut ersichtlich, dass die Proben mit einer Sinterschicht die erforderliche Belastung erreichen. So zeigt die Probe #8 ohne Sinterschicht eine schlechtere Haftung als die vergleichbare Probe #50 mit einer vorgängig aufgebrachten Sinterschicht. Die Proben mit sehr hohen Scherbelastungen von mehr als 2 kg/mm2 sind nicht mehr zwingend charakterisierend für die Haftung des Dielektrikums auf dem Kupfersubstrat. Bei sehr hohen Scherkräften kommt es oft zum Versagen der Lötstelle, oder sogar zum Bruch des SMD-Widerstands.

| Probennummer | maximale Scherbelastung kg/mm2 |
|---|---|
| Grenzwert laut MIL STD883G | 0.62 |
| #8 IP9319 | 1.57 |
| #13 | 1.42 |
| #26 Sinter, Nanokupfer | 1.50 |
| #33 Sinter, MgO | 1.31 |
| #43 Sinter, LS-662 | 2.47 |
| #50 Sinter, IP9319 | 2.27 |

Aufgrund der sich beim Ein- und Ausschalten ergebenden Temperaturwechsel ist die - Festigkeit in Kombination mit dem "Die-Shear-Strength-Test" vorgenommen worden. Die Proben wurden vor dem "Die-Shear-Strength-Test" zuerst mit 100 Zyklen von -55°C bis +125°C thermisch belastet. Anschliessend wurde der Schertest durchgeführt. Damit soll ermittelt werden, wie resistent die Proben im realen Betrieb auf ständige Temperaturschwankungen sind. Der Test ist somit eine weitere Verschärfung im Vergleich zu dem vorhergehend beschriebenen Schertest.

Es wurde 8x2 Proben mit Temperaturzyklen belastet, die als Übergang zwischen Substrat 10 und Isolationsschicht 50 eine Sinterschicht aus Kupfer aufweisen. Die Proben haben unterschiedliche Aufbauten der Isolationsschichten (Füllstoffe, Schichtdicken, Sinterschichtdicke). Alle Proben weisen nach den 100 Temperaturzyklen eine optisch gute Haftung auf. Es sind keine Absplitterungen erkennbar. Keine der Proben hatte sich nach der Temperaturzyklenprüfung deutlich mehr verworfen. Die meisten Proben haben sich entspannt und wiesen nach den Temperaturzyklen weniger Verwerfung auf.

Von Bedeutung für den praktischen Einsatz ist die Isolationsfestigkeit. Hierbei wurde die Isolationsfestigkeit bei Schichtdicken von 20-60µm gestestet. Durch den Sinterprozess wurden gewollt Unebenheiten eingebracht, die kleine Spitzen von einigen µm verursachen. Diese Spitzen ragen nach dem Einbrennen des Dielektrikums in die Isolationsschicht, so dass eine Schichtdicke von 30 bis 50 Mikrometer bevorzugt ist. Diese leichte Erhöhung der Schichtdicke, damit die Isolationsfestigkeit über die ganze Schicht gewährleistet ist, kann in einem gleichmässigen Produktionsprozess allerdings minimiert werden und in den Bereich von 20 Mikrometer gedrückt werden.

Eine Zusammenstellung der in den Proben verwendeten Materialien ist:
Prometall: Cu-ETP; CW004A, Elektrische Leitfähigkeit min. 57 m Ω-1/mm2; EN-Werkstoff-Nr. CW004A; DIN-Werkstoff-Nr. 2.0060.
Prometall: Cu-OFE; CW008A, EN-Werkstoff-Nr. CW008A; DIN-Werkstoff-Nr. 2.0040; Sauerstofffrei
Dielektrikumspaste Heraeus IP9319; Material: Glas; Nennkorngrösse: ca. 12µm; Einbrenntemperatur: 900°C; Haltezeit auf Brenntemperatur: 9-11min; Feststoffanteil: 90% Dielektrikumspaste Heraeus IP9227; Material: Glas; Einbrenntemperatur: 850°C; Haltezeit auf Brenntemperatur: 12min; Feststoffanteil: 74.5%
Dielektrikumspaste Heraeus IP9037; Material: Glas; Einbrenntemperatur: 850°C; Haltezeit auf Brenntemperatur: 10min; Feststoffanteil: 66%
Dielektrikumspaste Heraeus GPA 2009-003; Material: Glas; Einbrenntemperatur: 850°C; Haltezeit auf Brenntemperatur: 10min; Feststoffanteil: 70%
Farbe: grün Tanaka LS-662; Material: Glas; Einbrenntemperatur: 900°C; Haltezeit auf Brenntemperatur: 10min; Feststoffanteil: 70%
ECKA Copper; Copper AK UF 20 Ag10 von Ecka Granules; Nennkorngrösse: 10µm; Form: kugelig; Ausdehnungskoeffizient a: 16.5-10-6/°K; Wärmeleitfähigkeit: 270-400W/(m·K);
ECKA Kontaktargan; Kontaktargan 10 von Ecka Granules; Nennkorngrösse: 10µm; Form: flockig; Ausdehnungskoeffizient a: 16.5-10-6/°K; Wärmeleitfähigkeit: 270-400W/(m·K)
Leiterbahnpaste Heraeus C7257; Material: Kupfer / Glas; Nennkorngrösse: ca. 10µm; Einbrenntemperatur: 900°C; Haltezeit auf Brenntemperatur: 9-11min; Feststoffanteil: 90% Diese Leiterbahnpaste wird per Siebdruck aufgebracht und wie das verwendete Dielektrikum bei 900°C eingebrannt.
Leiterbahnpaste Tanaka TR-8901; Material: Kupfer / Glas; Nennkorngrösse: ca. 10µm; Einbrenntemperatur: 900°C; Haltezeit auf Brenntemperatur: 9-11min; Feststoffanteil: 90% Die Leiterbahnpaste von Tanaka wird wie die Leiterbahnpaste von Heraeus verarbeitet. Die Schicht wird per Siebdruck aufgebracht und wie das verwendete Dielektrikum bei 900°C eingebrannt.

**BEZUGSZEICHENLISTE**

| | | | |
|---|---|---|---|
| 10 | Wärmesenke | 40 | Leistungsbauteil / LED |
| 20 | Submount / Unterbau | 41 | Sperrschicht |
| 21 | Metallisierung | 45 | Lichtstreu-Dom |
| 30 | Keramik | 50 | Isolationsschicht |
| 31 | Kontaktierung | 60 | Sinterschicht |
| 32 | Lot | | |
| 35 | Wärmeableitung | | |

## Patentansprüche

1. Verfahren zur Herstellung eines Halbleitermoduls, aufweisend ein Halbleiterelement (40), eine Isolationsschicht (50), eine Sinterschicht (60) und ein Kupfersubstrat (10), **dadurch gekennzeichnet, dass** das Verfahren in der angegebenen Reihenfolge die folgenden Verfahrensschritte umfasst:
- Aufbringen der Sinterschicht (60) auf dem Kupfersubstrat (10), wobei die Sinterschicht eine Sinter-Kupferschicht (60) ist,
- Aufbringen der Isolationsschicht (50) auf der Sinter-Kupferschicht (60) und
- Anordnen des Halbleiterelementes (40) auf der Isolationsschicht (50).

2. Verfahren nach Anspruch 1, **dadurch gekennzeichnet, dass** die Sinter-Kupferschicht (60) aus Kupferpulver oder einem Kupfer-Metall Pulver Gemisch und einem organischen Verdünnungsmittel besteht.

3. Verfahren nach Anspruch 2, **dadurch gekennzeichnet, dass** das Kupferpulver eine Nennkorngrösse von 5 bis 20 Mikrometer, insbesondere von 10 Mikrometer hat, und/oder dass das Kupferpulver in Flockenform vorliegt.

4. Verfahren nach einem der Ansprüche 1 bis 3, **dadurch gekennzeichnet, dass** das Kupfer eine sauerstofffreie Kupferlegierung ist.

5. Verfahren nach einem der Ansprüche 1 bis 4, dass die Sinterkupferschicht (60) auf das Kupfersubstrat (10) durch Siebdruck aufgetragen und unter einer Stickstoffatmosphäre ausgehärtet wird, vorteilhafterweise bei einer Temperatur von 800 bis 950 Grad Celsius.

6. Verfahren nach einem der Ansprüche 1 bis 5, dass eine Dielektrikumspaste (50) als die Isolationsschicht auf und in die Sinterkupferschicht (60) auf dem Kupfersubstrat (10), insbesondere durch Siebdruck, aufgetragen wird und anschliessend ausgehärtet wird, vorteilhafterweise bei einer Temperatur von 800 bis 950 Grad Celsius.

7. Verfahren nach einem der Ansprüche 1 bis 6, dass eine Leiterbahnpaste auf die unteren Schichten (60 oder 50) auf dem Kupfersubstrat (10), insbesondere durch Siebdruck, aufgetragen wird und anschliessend ausgehärtet wird, vorteilhafterweise bei einer Temperatur von 800 bis 950 Grad Celsius.

8. Verfahren nach einem der Ansprüche 1 bis 7, wobei die Sinterschicht (60), die Isolationsschicht (50) und ggf. die Leiterbahnschicht durch Dickschichttechnik aufgebracht wird.

9. Verfahren nach einem der Ansprüche 1 bis 8, wobei das Halbleitermodul eine lichtemittierende Diode umfasst.

10. Verfahren nach einem der Ansprüche 1 bis 9, wobei die Schichtdicke der Isolationsschicht (50) zwischen 20 und 60 Mikrometern liegt.

11. Halbleitermodul, umfassend einen auf einem Kupfersubstrat (10) mit dazwischen liegender Isolationsschicht (50) aufgebrachten Halbleiter (40), wobei zwischen dem Kupfersubstrat (10) und der Isolationsschicht (50) eine Sinterschicht (60) vorgesehen ist, **dadurch gekennzeichnet, dass** die Sinterschicht eine Sinter-Kupferschicht ist, die direkt auf dem Kupfersubstrat (10) aufgebracht ist, und dass die Isolationsschicht (50) direkt auf der Sinter-Kupferschicht angeordnet ist.

12. Halbleitermodul nach Anspruch 11, wobei zwischen Isolationsschicht (50) und dem Halbleiter eine Metallisierungsschicht (21), insbesondere eine Leiterbahnschicht, vorgesehen ist.

13. Halbleitermodul nach Anspruch 12, wobei der Halbleiter in einem Submount (20) integriert ist.

## Claims

1. A method of manufacturing a semiconductor module comprising a semiconductor element (40), an insulating layer (50), a sintering layer (60) and a copper substrate (10), **characterised in that** the method comprises the following steps in the order given:
- depositing said sinter layer (60) on said copper substrate (10), wherein said sinter layer is a sinter copper layer (60),
- application of the insulation layer (50) on the sintered copper layer (60) and
- placing the semiconductor element (40) on the insulating layer (50).

2. The method according to claim 1, **characterized in that** the sintered copper layer (60) consists of copper powder or a copper-metal powder mixture and an organic diluent.

3. The method according to claim 2, **characterized in that** the copper powder has a nominal grain size of 5 to 20 micrometers, in particular of 10 micrometers, and/or **in that** the copper powder is present in flake form.

4. The method according to any one of claims 1 to 3, **characterized in that** the copper is an oxygen-free copper alloy.

5. The method according to any one of claims 1 to 4, **characterized in that** the sintered copper layer (60) is applied to the copper substrate (10) by screen printing and cured in a nitrogen atmosphere, advantageously at a temperature of 800 to 950 degrees Celsius.

6. The method according to any one of claims 1 to 5, **characterized in that** a dielectric paste (50) is applied as the insulating layer to and into the sintered copper layer (60) on the copper substrate (10), in particular by screen printing, and then cured, advantageously at a temperature of 800 to 950 degrees Celsius.

7. The method according to any one of claims 1 to 6, **characterized in that** a conductive paste is applied to the lower layers (60 or 50) on the copper substrate (10), in particular by screen printing, and then cured, advantageously at a temperature of 800 to 950 degrees Celsius.

8. The method according to any one of claims 1 to 7, wherein the sintered layer (60), the insulation layer (50) and, if applicable, the conductor track layer are applied by thick-film technology.

9. The method according to any one of claims 1 to 8, wherein the semiconductor module comprises a light-emitting diode.

10. The method according to any one of claims 1 to 9, wherein the layer thickness of the insulating layer (50) is between 20 and 60 micrometers.

11. A semiconductor module comprising a semiconductor (40) deposited on a copper substrate (10) with an insulation layer (50) therebetween, a sinter layer (60) being provided between the copper substrate (10) and the insulation layer (50), **characterized in that** the sinter layer is a sinter copper layer deposited directly on the copper substrate (10), and **in that** the insulation layer (50) is disposed directly on the sinter copper layer.

12. The semiconductor module according to claim 11, wherein a metallization layer (21), in particular a conductor track layer, is provided between the insulation layer (50) and the semiconductor.

13. The semiconductor module according to claim 12, wherein the semiconductor is integrated in a submount (20).

## Revendications

1. Procédé de fabrication d'un module semi-conducteur comprenant un élément semi-conducteur (40), une couche isolante (50), une couche de frittage (60) et un substrat en cuivre (10), **caractérisé en ce que** le procédé comprend les étapes suivantes dans l'ordre indiqué :
- le dépôt de ladite couche de frittage (60) sur ledit substrat de cuivre (10), dans lequel ladite couche de frittage est une couche de cuivre fritté (60),
- l'application de la couche isolante (50) sur la couche de cuivre frittée (60) et
- le placement de l'élément semi-conducteur (40) sur la couche isolante (50).

2. Procédé selon la revendication 1, **caractérisé en ce que** la couche de cuivre frittée (60) est constituée de poudre de cuivre ou d'un mélange de poudre de cuivre et de métal et d'un diluant organique.

3. Procédé selon la revendication 2, **caractérisé en ce que** la poudre de cuivre présente une granulométrie nominale de 5 à 20 micromètres, en particulier de 10 micromètres, et/ou **en ce que** la poudre de cuivre est présente sous forme de flocons.

4. Procédé selon l'une quelconque des revendications 1 à 3, **caractérisé en ce que** le cuivre est un alliage de cuivre exempt d'oxygène.

5. Procédé selon l'une quelconque des revendications 1 à 4, **caractérisé en ce que** la couche de cuivre frittée (60) est appliquée par sérigraphie sur le substrat de cuivre (10) et durcie dans une atmosphère d'azote, avantageusement à une température de 800 à 950 degrés Celsius.

6. Procédé selon l'une quelconque des revendications 1 à 5, **caractérisé en ce qu'**une pâte diélectrique (50) est appliquée comme couche isolante sur et dans la couche de cuivre frittée (60) sur le substrat en cuivre (10), en particulier par sérigraphie, et ensuite durcie avantageusement à une température de 800 à 950 degrés Celsius.

7. Procédé selon l'une quelconque des revendications 1 à 6, **caractérisé en ce qu'**une pâte conductrice est appliquée sur les couches inférieures (60 ou 50) du substrat en cuivre (10), notamment par sérigraphie, puis durcie avantageusement à une température de 800 à 950 degrés Celsius.

8. Procédé selon l'une quelconque des revendications 1 à 7, dans lequel la couche frittée (60), la couche isolante (50) et, le cas échéant, la couche de piste conductrice sont appliquées par la technique des couches épaisses.

9. Procédé selon l'une quelconque des revendications 1 à 8, dans lequel le module semi-conducteur comprend une diode électroluminescente.

10. Procédé selon l'une quelconque des revendications 1 à 9, dans lequel l'épaisseur de la couche isolante (50) est comprise entre 20 et 60 micromètres.

11. Module semi-conducteur comprenant un semi-conducteur (40) déposé sur un substrat en cuivre (10) avec une couche isolante (50) entre les deux, dans lequel une couche frittée (60) est prévue entre le substrat en cuivre (10) et la couche isolante (50), **caractérisé en ce que** la couche frittée est une couche de cuivre frittée déposée directement sur le substrat en cuivre (10), et **en ce que** la couche isolante (50) est disposée directement sur la couche de cuivre frittée.

12. Module semi-conducteur selon la revendication 11, dans lequel une couche de métallisation (21), en particulier une couche de piste conductrice, est prévue entre la couche isolante (50) et le semi-conducteur.

13. Module semi-conducteur selon la revendication 12, dans lequel le semi-conducteur est intégré dans une embase (20).
